# EUROPÄISCHE PATENTSCHRIFT

(11) **EP 1 354 181 B1**
(45) Veröffentlichungstag und Bekanntmachung des Hinweises auf die Patenterteilung: **02.12.2009**
(21) Anmeldenummer: 01900141.1
(22) Anmeldetag: 08.01.2001
(51) Int. Cl.: G01L 5/00

(54) **SENSOR ZUR ZUSTANDSBESTIMMUNG VON KENNGRÖSSEN AN MECHANISCHEN KOMPONENTEN UNTER VERWENDUNG VON AMORPHEN KOHLENSTOFFSCHICHTEN MIT PIEZORESISTIVEN EIGENSCHAFTEN**
SENSOR FOR DETERMINING THE STATE OF PARAMETERS ON MECHANICAL COMPONENTS USING AMORPHOUS CARBON LAYERS HAVING PIEZORESISTIVE PROPERTIES
CAPTEUR POUR DETECTER L'ETAT DE PARAMETRES DE COMPOSANTS MECANIQUES PAR UTILISATION DE COUCHES DE CARBONE AMORPHES AYANT DES PROPRIETES PIEZORESISTIVES

(43) Veröffentlichungstag der Anmeldung: 22.10.2003
(73) Patentinhaber: Fraunhofer-Gesellschaft zur Förderung der angewandten Forschung e.V., 80686 München (DE)
(72) Erfinder: LÜTHJE, Holger, 25469 Halstenbeck (DE); BRAND, Jochen, 38100 Braunschweig (DE)
(74) Vertreter: Einsel, Martin
(86) Internationale Anmeldenummer: PCT/EP2001/000147
(87) Internationale Veröffentlichungsnummer: WO 2002/054031

(56) Entgegenhaltungen:
- EP-A- 0 844 469
- EP-A- 1 057 586
- GRIGOROVICI R ET AL: "Properties of amorphous carbon films" 4TH INTERNATIONAL CONFERENCE ON AMORPHOUS AND LIQUID SEMICONDUCTORS, ANN ARBOR, MI, USA, 9-13 AUG. 1971, Bd. 8-10, Seiten 793-797, XP000995653 Journal of Non-Crystalline Solids, June 1972, Netherlands ISSN: 0022-3093
- DEVENYL A ET AL: "Electrical transport in amorphous carbon films" 2ND INTERNATIONAL CONFERENCE ON CONDUCTION IN LOW MOBILITY MATERIALS, ELIAT, ISRAEL, 5-8 APRIL 1971, Seiten 217-228, XP000995744 1971, London, UK, Taylor & Francis, UK

## Beschreibung

Die vorliegende Erfindung betrifft ganz allgemein eine Messmethodik zur Bestimmung von Zustandsgrößen wie Druck, Kraft und mechanische Belastung von mechanischen Komponenten wie zum Beispiel Maschinenbauteilen und Werkzeugen, unter Verwendung von amorphen wasserstoffhaltigen Kohlenstoffschichten mit piezoresistiven Eigenschaften.

Die Kenntnis und Beobachtung des aktuellen Zustandes von beanspruchten oder belasteten Oberflächen von Bauteilen oder Werkzeugen ist für die Steuerung und Optimierung von Verarbeitungsprozessen von maßgeblicher Bedeutung.

Es besteht daher ein Bedarf an Vorrichtungen und Verfahren mit denen wirtschaftlich auf einfache Art und Weise die interessierenden Kenngrößen (Druck, Krafteinwirkung etc.) möglichst direkt am Ort der Entstehung/Einwirkung und im Fall von Maschinen möglichst im Betrieb zuverlässig und reproduzierbar gemessen werden können.

Um den starken Kräften widerstehen zu können, die an den Arbeitsflächen von Werkzeugen oder an den belasteten Oberflächen von Maschinenbauteilen auftreten können, müssen derartige Messvorrichtungen zur Bestimmung der aktuellen Zustandsgrößen ausreichend verschleißfest sein. Je nach Anwendung zum Beispiel in Reibpaarungen sollten sie gleichzeitig zu den elektrischen Funktionen einen geringen Reibungswiderstand aufweisen.

In der EP 0 685 297 und WO 87/04236 werden Sensoren zur Bestimmung von Zustandsgrößen direkt an der Verschleißfläche von Werkzeugen für die Umform-und Zerspantechnik, das heißt an der Schneidkante beziehungsweise Spanfläche, und an den Arbeitsflächen von den unterschiedlichsten Maschinenbauteilen beschrieben, wobei mit Dünnschichttechniken und mittels lithographischer Methoden an den interessierenden Stellen der Bauteile Leiterbahnen und Schaltkreise zur Bestimmung der je nach Bauteiltyp interessierenden Größen, hier insbesondere Verschleiß und Temperatur, aufgebracht sind. Die dort beschriebenen Sensoren ermöglichen zwar die direkte Messung der Zustandsgrößen am Ort der Entstehung beziehungsweise auch im Betrieb des betreffenden Maschinenbauteils, jedoch erfordert die Herstellung der Leiterbahnen und Schaltkreise einen mehrstufigen Arbeitsvorgang. Darüber hinaus müssen sie durch Schutzschichten vor Verschleiß und den auftretenden starken Kräften geschützt werden. Dies gilt insbesondere für Anwendungen, bei denen die abrasiven oder adhäsiven Belastungen des Materials hoch sind, wie zum Beispiel an den Arbeitsflächen von Werkzeugen.

Ein weiteres Beispiel für mechanische Komponenten, für die die Bestimmungen von Zustandsgrößen für die Arbeitsvereinfachung von Bedeutung ist, sind Verbindungselemente, wie Schrauben, Nieten, Muttern, oder Unterlegscheiben etc. Interessierende Zustandsgrößen sind hier zum Beispiel die Vorspannkraft zum Einstellen der richtigen Schraubenvorspannung oder die Anpresskraft zur Feststellung, ob das Verbindungselement ausreichend fest sitzt beziehungsweise ob es sich gelockert hat.

So wird in der DE 44 19 009 eine Messeinrichtung zum Messen der Vorspannkraft einer Verschraubung beschrieben, wobei eine Unterlegscheibe derart ausgestaltet ist, dass sie neben dem zentralen Schraubenloch eine radiale oder sekanten ähnliche Bohrung aufweist, wobei die lastabhängige Verformung dieser zweiten Bohrung kapazitiv gemessen wird. Für eine korrekte Messung kommt es hierbei entscheidend auf eine exakt vorgegebene zweite Bohrung an.

In der Vorrichtung gemäß der DE 693 11 479 erfolgt die Messung der Anpresskraft über die Biegung eines auf dem Verbindungselement befestigten Kraftaufnehmers, der sich bei einem Anziehvorgang reproduzierbar in Abhängigkeit der ausgeübten Kraft verformt.

EP 1 057 586 A2 betrifft ein Modul, dass auf seiner Oberfläche Dünnschichtsensoren enthält und in ein Werkzeug eingepasst werden kann. Der Dünnschichtsensor ist dabei aus einem Schichtsystem aufgebaut, das zumindest einen Grundkörper, und eine darüber liegende sensorische Schicht enthält, wobei die sensorische Schicht ihrerseits von einer weiteren Funktionsschicht bedeckt ist. Zusätzlich können elektrisch isolierende Schichten vorhanden sein.
Die sensorische Schicht kann aus einer Dehnungsmessbrücke, einem piezoelektrischem Dünnschichtsensor und/oder einem piezoresistiven Dünnschichtsensor bestehen. Konkrete Angaben, welche Materialien für welche Art von Dünnschichtsensor geeignet sind, finden sich jedoch nicht.
Soweit auf diamantähnliche, auf kohlenstoffbasierende amorphe Schichtsysteme wie DLC oder Me:DLC Bezug genommen wird, wird auf deren tribulogische Eigenschaften sowie interessante elektrische, optische und magnetische Eigenschaften verwiesen.

In GRIGOROVICI R ET AL: "Properties of amorphous carbon films" 4TH INTERNATIONAL CONFERENCE ON AMORPHOUS AND LIQUID SEMICONDUCTORS, ANN ARBOR, MI, USA, 9-13 AUG. 1971, Bd. 8-10, Seiten 793-797, Journal of Non-Crystalline Solids, June 1972, Netherlands ISSN: 0022-3093 sowie in DEVENYL A ET AL: "Electrical transport in amorphous carbon films" 2ND INTERNATIONAL CONFERENCE ON CONDUCTION IN LOW MOBILITY MATERIALS, ELIAT, ISRAEL, 5-8 APRIL 1971, Seiten 217-228, 1971, London, UK, Taylor & Francis, UK wird die piezoresitive Eigenschaft von amorphen Kohlenstoffschichten untersucht, die mittels Elektronstrahlverdampfung erzeugt worden sind. Nach dem dort beschriebenen Verfahren lassen sich jedoch keine harten verschleißfesten diamantartigen amorphen Kohlenwasserstoffschichten erhalten. Zur Ausbildung solcher diamantartigen amorphen Kohlenwasserstoffschichten muss die sich bildende Schicht mit Teilchen einer wesentlich höheren Energie beschossen werden, wie es beispielsweise mit einem plasmabasierten Verfahren, wie es in der vorliegenden Anmeldung eingesetzt, möglich ist. Zudem handelt es sich bei den hier untersuchten Schichten um reine Kohlenstoffschichten.

Es bestand ein Bedürfnis nach einer Messmethodik zur Bestimmung von Zustandsgrößen, insbesondere der Krafteinwirkung und dem Druck, mit der aktuell der jeweilige Zustand der interessierenden Fläche einer beliebigen mechanischen Komponente gemessen werden kann, die zudem verschleißbeständig ist, geringe Gleitreibungskoeffilzienten aufweist sowie universal ohne große Abänderungen für die unterschiedlichsten Anwendungsfälle angepasst und eingesetzt werden kann.

Erfindungsgemäß wird diese Aufgabe gelöst durch die Verwendung einer amorphen Kohlenstoffschicht mit piezoresistiven Eigenschaften als Sensor zur Messung von aktuellen Zustandsgrößen an beanspruchten Oberflächen von mechanischen Komponenten gelöst, wobei die amorphe Kohlenstoffschicht eine Kohlenwasserstoffschicht mit 0,1 bis 35 at-% Wasserstoff ist und als einzelne Schicht oder als Schichtsystem die beanspruchte Oberfläche beschichtet.

Im Sinne der Erfindung können "amorphe Kohlenstoffschichten" Kohlenstoffschichten ohne Wasserstoff sein, sogenannte i-Carbon (i-C)-Schichten, oder auch Kohlenwasserstoffschichten, sogenannte a-C:H-Schichten beziehungsweise DLC-Schichten (Diamant-like-Carbon), mit oder ohne weiteren metallischen und/oder nichtmetallischen Dotierungselementen.

Sogenannte Hartstoffschichten aus amorphen Kohlenwasserstoff, abgekürzt a-C:H-Schichten oder auch DLC-Schichten (Diamant-Like-Carbon) bezeichnet, sind an sich bekannt und vielfältig in der Literatur beschrieben (zum Beispiel R. E. Clausing et.al. "Diamant and Diamant-Like Films and coatings", Plenum Press, New York, 1991). Sie zeichnen sich insbesondere durch hohe Härte, Verschleißbeständigkeit und niedrige Reibwerte aus und werden daher vielfach als Verschleißschutzschichten eingesetzt.

Es ist weiter bekannt, dass sich die Eigenschaften dieser Schichten, wie das Abnutzungs- beziehungsweise Adhäsionsverhalten oder auch die Reibwerte durch Zusatz von weiteren Elementen beeinflussen lassen und definiert für den jeweiligen Anwendungsfall eingestellt werden können.

So wird in der EP-0-A 087 836 vorgeschlagen, diesen Schichten metallische Elemente zuzusetzen, um den nachteiligen Einfluss der relativen Luftfeuchtigkeit auf die Reibwerte zu vermindern.

Vollkommen überraschend und unerwartet wurde gefunden, dass sich amorphe diamantähnliche Kohlenstoffschichten, insbesondere wenn sie zusätzlich metallische und/oder nichtmetallische Elemente enthalten, ähnlich verhalten wie piezoresistive Materialien und bei Belastung, zum Beispiel durch Druck, eine messbare Änderung des elektrischen Widerstandes zeigen. Obwohl derartige Kohlenstoffschichten vielfach Anwendung finden als Verschleißschutzschichten, ist die Beobachtung der piezoresistiven Eigenschaften vollkommen neu und noch nirgends vorbeschrieben. Mit den piezoresistiven Eigenschaften eröffnen sich für derartige Kohlenstoffschichten vielfältige weitere Anwendungsgebiete, insbesondere auf dem Gebiet der Sensorik.

Mit Hilfe der piezoresistiven Eigenschaften können diese Kohlenstoffschichten unmittelbar als Sensor zur Bestimmung von aktuellen Zustandsgrößen, wie Druck oder Krafteinwirkung, von mit diesen Schichten beschichteten mechanischen Komponenten, wie zum Beispiel den vorstehend beschriebenen Maschinenbauteilen, Werkzeugen oder Verbindungselementen, dienen, ohne dass weitere Maßnahmen erforderlich sind.

Da diese Schichten auch auf Oberflächen mit den unterschiedlichsten Geometrien aufgebracht werden können, können sie universal für die unterschiedlichsten mechanischen Komponenten und insbesondere auch mit komplizierten Oberflächenstrukturen, wie Ecken oder Kanten, eingesetzt werden.

Durch den Einsatz von Kohlenstoffschichten mit piezoresistiven Eigenschaften können Sensoren zur Bestimmung von aktuellen Zustandsgrößen von beanspruchten Oberflächen geschaffen werden, die ohne besondere Herstellungs- oder Anpassungsmaßnahmen universal einsetzbar sind. Mit derartigen Sensoren ist die direkte Messung auch an punktuell begrenzten Flächen selbst bei großflächigen Anwendungen möglich, und es können lokale Aussagen über den aktuellen Zustand - auch von lokal begrenzten - Messflächen erhalten werden. Durch die Ausnutzung der piezoresistiven Eigenschaften dieser Schichten kann eine vollkommen neuartige integrale Sensorik geschaffen werden.

Anders als bei den bekannten piezoresistiven Materialien können bei diesen Kohlenstoffschichten das Widerstandsniveau und die Druck-Widerstandskennlinien in Abhängigkeit von der Art und der Menge an eingebauten Dotierungselementen, vorzugsweise Metallatomen, definiert eingestellt werden.

So weisen beispielsweise metallfreie DLC-Schichten spezifische Widerstände von mehr als 10¹² Ω x cm auf, durch den Einbau von zum Beispiel metallischen Zusatzelementen lässt sich der Widerstand jedoch erniedrigen und kann einen Wert in der Größenordnung von etwa 10⁴ Q x cm annehmen.

Die erfindungsgemäß als Sensor eingesetzten Kohlenstoffschichten können mittels der bekannten Chemical- oder Physical-Vapor-Deposition-Techniken erhalten werden, wie sie vielfach in der Literatur beschrieben werden (beispielsweise ist in der EP-B-0 087 836 ein derartiges Verfahren zur Herstellung von metallhaltigen amorphen Kohlenwasserstoffschichten im Detail erläutert).

Typische Schichtdicken für die als Sensor einzusetzenden Kohlenstoffschichten liegen in einem Bereich von 10 nm - 500 µm, vorzugsweise von 10 nm bis 20 µm. Es versteht sich, dass die Schichtdicke je nach dem konkreten Anwendungsfall frei wählbar ist.

Prinzipiell können alle metallischen oder nichtmetallischen Elemente des Periodensystems für den Einbau in die Kohlenstoffschichten eingesetzt werden, das heißt als Dotierungselemente, solange die erhaltenen Schichten piezoresistives Verhalten aufweisen. Besonders geeignete Beispiele sind Si, Ti, W, Cr, Ta, Nb, V, Zr, Hf, Mo, Pd, Ni, Co, Pb, Cu, Al sowie Edelmetalle wie Au, Ag, Pt, Ru, wobei Si, Ti, W und Cr besonders bevorzugt sind. Für die vorliegende Erfindung umfasst der Begriff "metallisches Element" auch Elemente, die den Halbmetallen zuzurechnen sind.

Beispiele für nichtmetallische Dotierungselemente sind Sauerstoff, Stickstoff, Argon und Fluor. Die Elemente können in die Schicht als Einzelatome, Cluster oder aber auch Dotierungs Carbide eingebaut werden.

Durch die Wahl der Art der eingebauten Elemente und deren Konzentration lässt sich der spezifische Widerstand der damit erhaltenen Schicht in weiten Grenzen frei einstellen, so dass je nach gewünschter Anwendung das Widerstandsniveau und die Druck-Widerstandskennlinie definiert eingestellt werden kann. Es lassen sich somit piezoresistive Schichten mit einstellbaren elektrischen Eigenschaften erhalten.

Hierbei wird das metallische Dotierungselement im Allgemeinen in Form von sogenannten Nanopartikeln, die in der Regel eine Größe von 5 bis 500 nm aufweisen, in die amorphe Kohlenstoffmatrix eingelagert, wobei die Abstände zwischen den Nanopartikeln in etwa die gleiche Größenordnung aufweisen. Es wird angenommen, dass die Stromführung über diese eingelagerten Partikel erfolgt. Überraschenderweise wurde nunmehr erfindungsgemäß gefunden, dass der Widerstand dieser Schichten von der äußeren Belastung wie Druckbelastung oder Deformation durch Dehnung abhängig ist.

Diese Eigenschaft beschränkt sich nicht auf die dotierungselementhaltigen metallhaltigen Kohlenstoffschichten sondern tritt auch in reinen amorphen Kohlenstoffschichten ohne Dotierungselemente auf. Es wird angenommen, dass in diesem Fall die piezoresistiven Eigenschaften auf die Ausbildung von Inseln mit überwiegenden sp²-Charakter, das heißt mit graphitähnlichen Bindungsverhältnissen, in einer Kohlenstoffmatrix mit sp³-Charakter, das heißt diamantähnlichen Bindungsverhältnissen, bewirkt wird.

Beispielsweise kann die erfindungsgemäß eingesetzte Kohlenstoffschicht Kohlenstoff in einem Anteil von 20 - 99,9 at-%, vorzugsweise 20 - 95 at-%, Wasserstoff in einem Anteil von 0,1 - 35 at-%, vorzugsweise 5 - 35 at-% und Dotierungselemente zum Beispiel in einem Anteil von 0,01 - 35 at-%, vorzugsweise 1 - 45 at-% enthalten.

Selbstverständlich können die vorstehend genannten Anteile je nach den speziellen Anforderungen des konkreten Anwendungsfalles nach oben oder unten variiert werden.

Erfindungsgemäß kann die Kohlenstoffschicht ein Mehrschichtsystem mit unterschiedlicher Zusammensetzung hinsichtlich der Art und/oder Konzentration der Komponenten sein. Sie kann als Gradientenschicht ausgebildet sein, deren Aufbau über die Schichtdicke variiert.

Die konkrete Ausgestaltung der erfindungsgemäß eingesetzten Kohlenstoffschicht unterliegt keinen besonderen Beschränkungen und kann entsprechend den Erfordernissen des konkreten Anwendungsfalls erfolgen.

Falls erforderlich, können zusätzlich weitere Schichten, wie zum Beispiel elektrisch isolierende Schutzschichten, Schichten zur Haftverbesserung oder Schichten zur elektrischen Kontaktierung vorgesehen werden.

Als isolierende Schicht eigenen sich zum Beispiel auch nichtleitende a:C-H-Schichten, die zur Erhöhung des Widerstandes mit Sauerstoff und Silizium dotiert sind.

Ein Beispiel dafür ist eine a:C-H-Schicht, die zusätzlich Silizium und ggf. Sauerstoff enthält. Zur Herstellung dieser Schichten können dem Prozessgas geeignete Vorläufermaterialien wie zum Beispiel Hexamethyldisiloxan zugesetzt werden. Schichten zur elektrischen Kontaktierung können aus dafür üblichen Metallen oder Hartstoffen bestehen.

Je nach gewünschtem Anwendungsfall können diese zusätzlichen Schichten im gleichen Prozess vor oder im Anschluss an die Ausbildung der Kohlenstoffschicht mit piezoresistiven Eigenschaften auf das jeweilige Substrat aufgebracht werden.

Die einzelnen Schichten können als diskrete Schichten ausgebildet sein, wobei jede Schicht für sich eine homogene Zusammensetzung über die jeweilige Schichtdicke aufweisen und verschiedene Schichten eine unterschiedliche Zusammensetzung im Hinblick auf die Art der Komponenten und die Komponentenmenge besitzen können.

Die Schichten können auch als Gradientenschichten ausgebildet sein, wobei innerhalb einer Schicht die Art der Komponenten und/oder deren Anteil über die Schichtdicke variiert. Je nach Anwendungsfall lässt sich die Ausgestaltung der Schicht/Schichten beziehungsweise des Schichtsystems frei gestalten. Beispiele für mögliche weitere Schichten und die Ausgestaltung von Schichtsystemen finden sich in der vorstehend benannten EP-A-0 685 297, auf die hierfür voll Bezug genommen wird.

In einer erfindungsgemäß bevorzugten Ausgestaltung besteht das auf das jeweilige Substrat aufgebrachte Schichtsystem aus sandwichartigen Mehrfachschichten zur gezielten Einstellung elektrischer und mechanischer Eigenschaften. Dabei können in vorteilhafter Weise Schichten mit unterschiedlichen Dotierstoffen und Konzentrationen verwendet werden.

Wie bereits vorstehend erwähnt, können die erfindungsgemäß eingesetzten Kohlenstoffschichten (i-C:H, a-C:H, Me-C:H) mittels der herkömmlichen PVD-oder CVD-Verfahren oder auch durch Kombination beider Verfahren erhalten werden. Hierbei wird für die Herstellung der entsprechenden Schichten das Dotierungselement oder die jeweiligen Elemente über Verdampfung oder Zerstäubung eines Festkörpers oder über elementhaltige Gase zugeführt.

Die Herstellung der Schichten beziehungsweise Mehrschichtsysteme kann zum Beispiel in einer handelsüblichen Mehrtagessputteranlage erfolgen oder in sogenannten Durchlaufanlagen.

Anwendungen für die Erfindung ergeben sich überall dort, wo eine Messung der Bauteilbelastung von Interesse ist und hohe Anforderungen an die Verschleißbeständigkeit, Anti-Haft-Eigenschaft und an den geringen Reibwert der Oberfläche gestellt werden. Beispiele hierfür sind Umform- und Zerspanwerkzeuge, Schneid- und Stanzwerkzeuge, Form- und Presswerkzeuge, Gleit- und Kugellagerungen, Rollenlager sowie Führungen.

Von Vorteil für den Einsatz als Sensor ist zudem, dass die Größe des Widerstands vom Messstrom abhängig ist. Durch diesen Effekt ist eine gezielte dynamische Anpassung der Sensorempfindlichkeit in einem großen Bereich durch entsprechende Nachführung der Stromdichte möglich.

Durch Laserbehandlung lassen sich zudem die Druck-/Spannungskennlinien der Sensorschicht punktuell gezielt einstellen, so dass lokal verschiedene Leitfähigkeiten erhalten werden können.

Für den Einsatz als Sensor werden die Kohlenwasserstoffschichten mit piezoresistiven Eigenschaften auf in der Sensorik übliche Weise mit elektrischen Kontakten versehen und mit entsprechenden Signalverarbeitungsbeziehungsweise Auswertungsschaltungen versehen.

In Kombination mit der erfindungsgemäß als Sensor eingesetzten Kohlenwasserstoffschicht können selbstverständlich weitere Sensoren in die betreffenden mechanischen Bauteile integriert sein, die direkt als Schicht ausgebildet sind oder auf andere Weise an dem mechanischen Bauteil vorgesehen werden, so dass eine Vielzahl von Zustandsgrößen erfasst werden kann.

So können Temperatursensoren vorgesehen werden, die eine thermische Stabilisierung ermöglichen. Der Einsatz von Temperatursensoren ist auch sinnvoll, um den Temperatureinfluss auf die erhaltenen Messwerte berücksichtigen und entsprechend herausrechnen zu können.

Beispielsweise kann der der erfindungsgemäßen Schicht inhärente Temperaturgang für die Temperaturmessung herangezogen werden. Hierbei erfolgt die Temperaturmessung an Stellen, die von Kraft- und Druckeinwirkungen unbelastet sind.

Nachstehend wird die vorliegend Erfindung beispielhaft anhand von Figuren näher erläutert.

Es zeigen:
- **Figuren 1 bis 3**: die Widerstandsänderung von mit verschiedenen metallischen Elementen dotierten Kohlenwasserstoffschichten in Abhängigkeit von der einwirkenden Kraft,
- **Figur 4**: die Widerstandsänderung von harten amorphen Kohlenwasserstoffschichten ohne Dotierung,
- **Figuren 5 bis 14**: verschiedene konkrete Anwendungen für den erfindungsgemäßen Sensor.

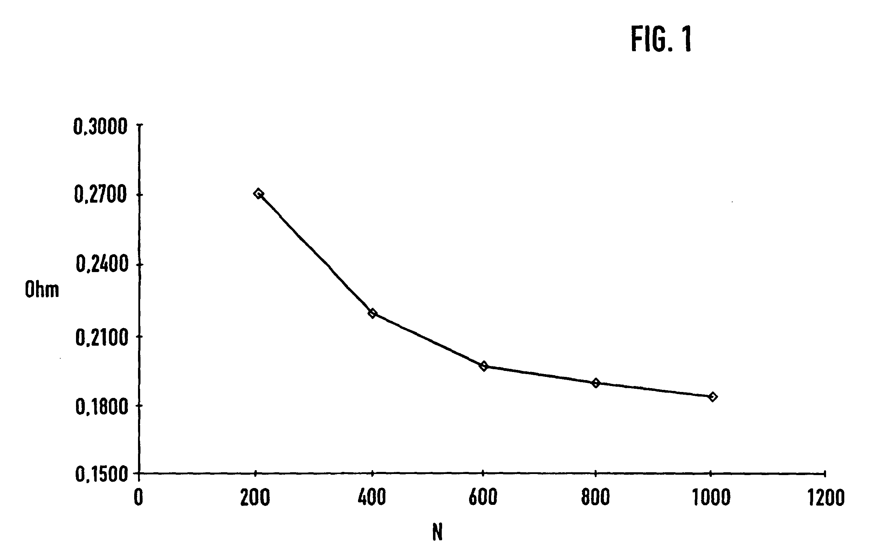

Die Diagramme in den Figuren 1 bis 4 zeigen deutlich die Änderung des Widerstands von verschieden dotierten beziehungsweiseundotierten Kohlenwasserstoffschichten in Abhängigkeit von der Kraft, die auf diese Schichten einwirkt.

In den Figuren 1 bis 4 wurden die Messungen mit einem zylindrischen Kontaktstempel mit einer ebenen Kontaktfläche durchgeführt, der einen Durchmesser von 1 nm besaß.
**Figuren 1 bis 2** zeigen die Widerstandsänderung bei Krafteinwirkung von harten amorphen Kohlenwasserstoffschichten mit Au-Nanokristallen, wobei in

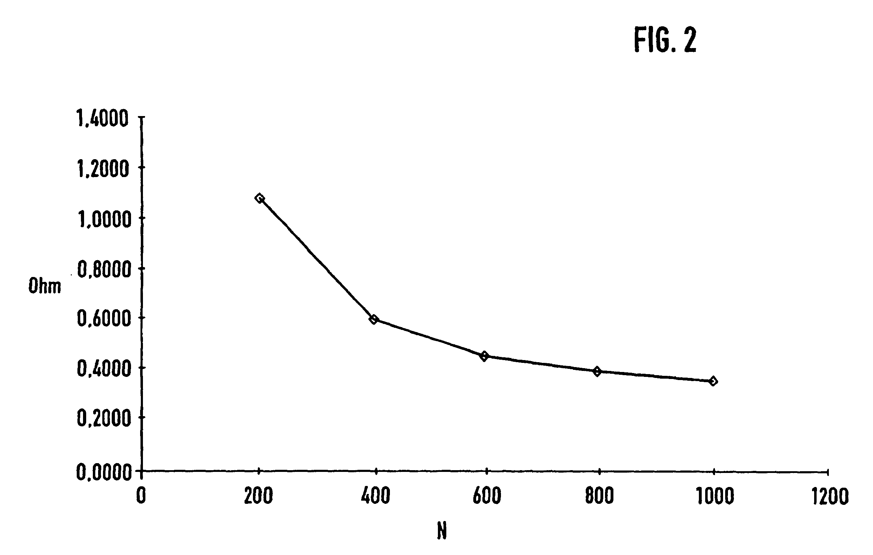

**Figur 1**: Au 43 at-%, C 54 at-% sowie weitere Dotierungselemente 3 at-%, und in **Figur 2****:** Au 30 at-%, C 68 at-% sowie weitere Dotierungselemente 2 at-%. Je nach Herstellungsverfahren enthalten diese Schichten bis zu 30 at-% Wasserstoff, der bei den vorstehenden Angaben über die Schichtzusammensetzung nicht berücksichtigt worden ist. Als Substrat wurde 100Cr6 eingesetzt.

Die Herstellung der Schichten erfolgte in einer Diodensputteranlage mit 150 mm Durchmesser belegt mit einem Au-Target (Gas: Ar 46 sccm/min; C₂H₂ 4 sccm/min; Targetleistung 500 W, 13,5 Mhz).

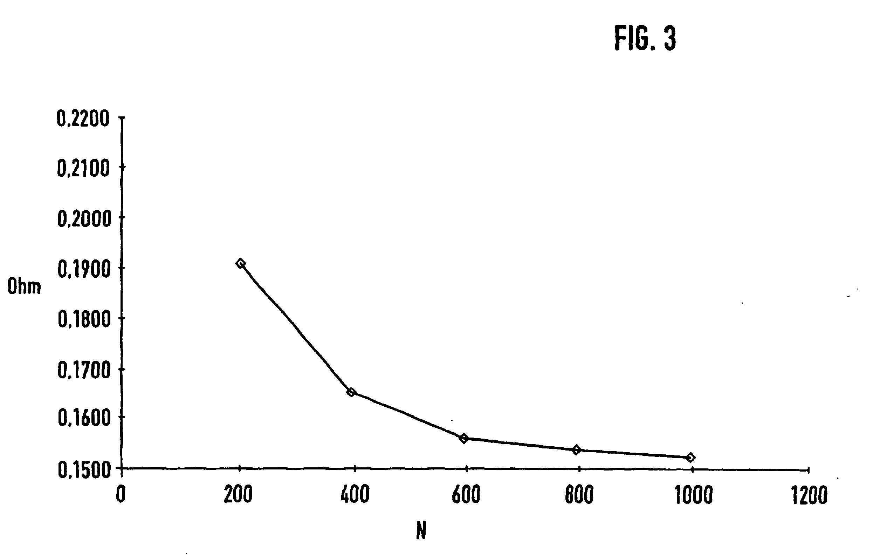

In **Figur 3** ist die Widerstandsänderung bei Krafteinwirkung von harten amorphen Kohlenwasserstoffschichten mit W beziehungsweise WC-Nanokristallen gezeigt mit W 10 at-%, C 88 at-%, andere Dotierungselemente 2 at-%. Die Schichten enthalten je nach Herstellungsverfahren bis zu 30 at-% Wasserstoff, der bei den vorstehenden Angaben über die Schichtzusammensetzung nicht berücksichtigt worden ist. Als Substrat wurde 100Cr6 eingesetzt, die Schichtdicke ist 2,2 µm.

Die Herstellung erfolgte in einer Magnetron-Sputteranlage mit 2 W-Targets von je 800 x 190 mm² (Gas: Ar 390 sccm/min; C₂H₂ 250 sccm/min; Targetleistung 2 x 6000 W, DC-Betrieb, Substratbias 100 V).

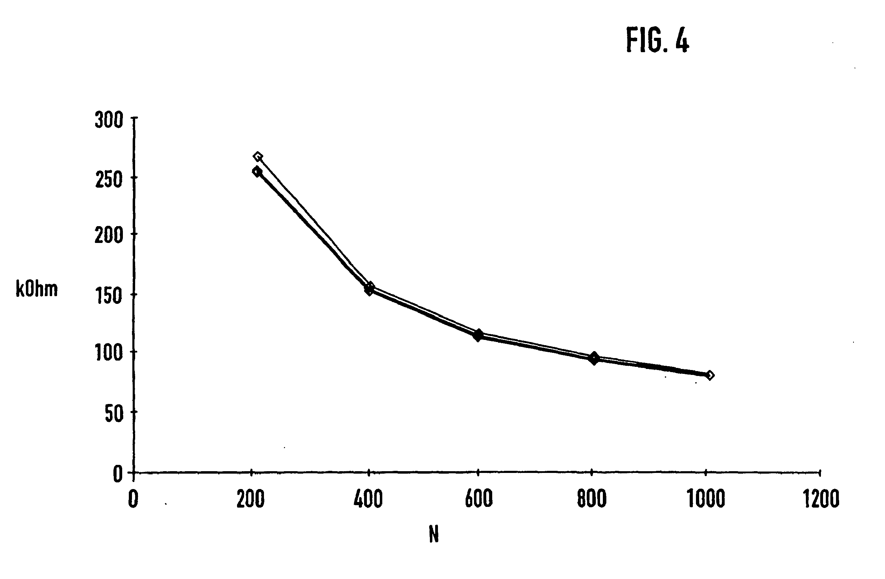

In **Figur 4** ist die Widerstandsänderung von harten amorphen Kohlenwasserstoffschichten ohne Metalldotierung gezeigt. Die Schichtdicke beträgt 2 µm. Als Substrat wurde 100Cr6 verwendet. Die Herstellungsbedingungen waren wie folgt: CVD-Sputteranlage mit Vertikalelektrode 200 x 150 mm²; Gas: Ar 70 sccm/min, C₂H₂ 20 sccm/min, Leistung: 500 W, 13,5 Mhz.

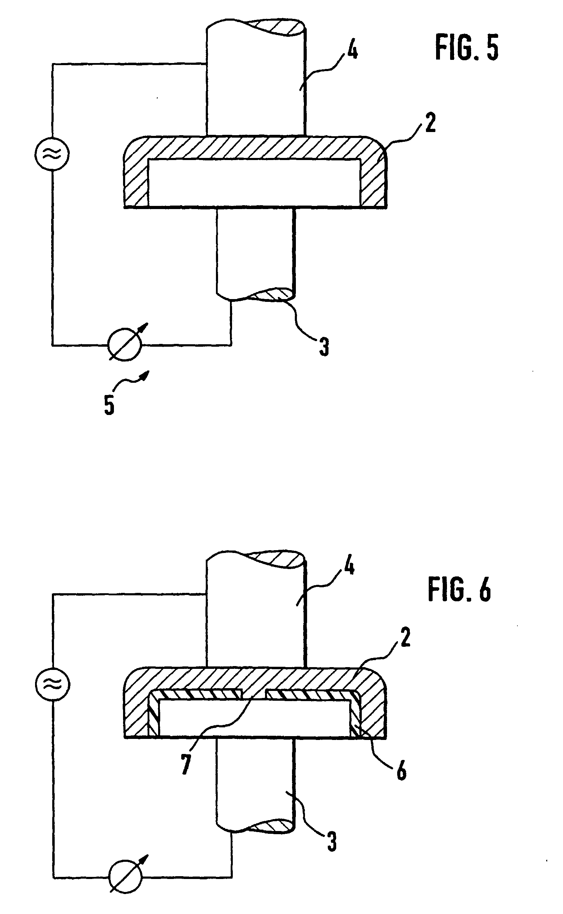

In den **Figuren 5 bis 14** sind konkrete Anwendungsformen der erfindungsgemäß eingesetzten Kohlenstoffschicht mit piezoresistiven Eigenschaften zur Messung von aktuellen Zustandsgrößen gezeigt.

In **Figur 5** ist die Anwendung der erfindungsgemäß als Sensor eingesetzten Schicht in einem Presswerkzeug dargestellt, das aus einem unteren Pressstempel 3 besteht, der mit der erfindungsgemäßen Messschicht 2 beschichtet ist, und einem Gegenkörper 4. Der zu pressende Werkstoff, zum Beispiel ein Blech, wird zwischen den Gegenkörper 4 und dem Stempel 3 eingeführt. Diese Anordnung erlaubt die Messung der aktuellen Kraft, die im Bereich der Kontaktfläche auf den Werkstoff einwirkt.

**Figur 6** zeigt eine ähnliche Anwendungsform wie Figur 5, jedoch mit verändertem Schichtaufbau auf dem Presswerkzeug, wodurch definierte lokale Messungen in gewünschten Zonen des Werkzeugs durchführbar sind.

Das Werkzeug wird hierbei zunächst mit einer dünnen und vorzugsweise mechanisch belastbaren isolierenden Schicht 6 beschichtet, wobei durch Aufbringung einer mechanischen Maske oder durch eine nachfolgend durchgeführte Strukturierung eine definierte Öffnung als Beobachtungsfenster 7 in der isolierenden Schicht 6 erzeugt wird. Die piezoresistivartige Messschicht 2 wird dann über die isolierende Schicht 6 gelegt. Das Beobachtungsfenster 7 erlaubt lokale Messungen in definierten Zonen.

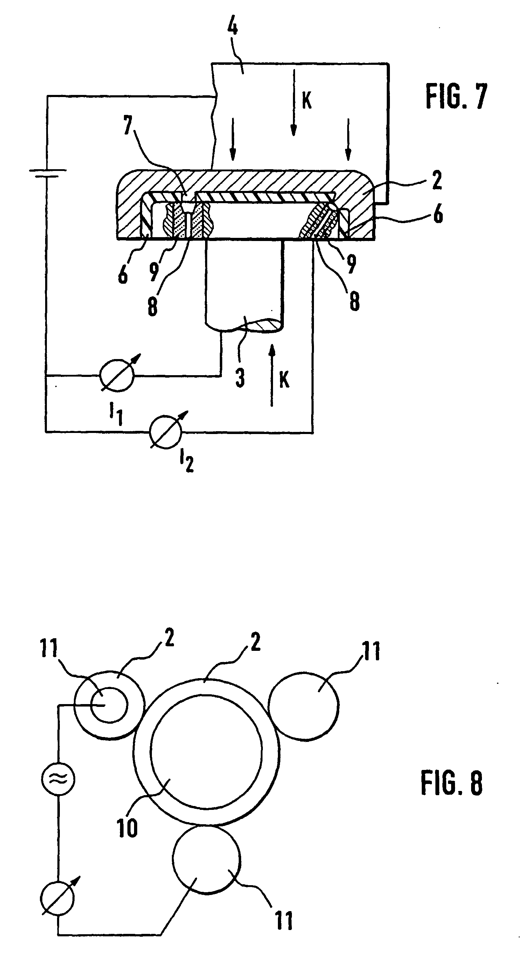

**Figur 7** zeigt wie Figuren 6 und 5 ein Presswerkzeug, wobei jedoch aus dem Pressstempel 3 isoliert Kontakte 8 herausgeführt sind. Auch hier erfolgt zunächst der Aufbau einer isolierenden Schicht 6 mit Beobachtungsfenstern 7 und dann Beschichtung mit der erfindungsgemäß eingesetzten Messschicht 2. Die Kontakte 8 sind ebenfalls von einer Isolationsschicht 9 umgeben. Diese Ausführungsform erlaubt die Anwendung einer Messmatrix mit Beobachtungsfenstern 7 als lokal definierten Messpunkten. Die Richtung der Krafteinwirkung ist durch die Pfeile K angedeutet.

**Figur 8** zeigt ein Rollenlaufwerk, wie es zum Beispiel in der Druckindustrie angewendet wird, mit einer Hauptrolle 10 und mehreren Andruckrollen 11. Die Messung der Andruckkraft wird realisiert, indem zumindest eine der Rollen mit der erfindungsgemäßen Schicht 2 versehen wird, hier die Hauptrolle 10, und der Widerstand entsprechend der eingezeichneten Schaltung bestimmt wird. Wie in der Figur angedeutet, können auch die Andruckrollen 11 (hier die Andruckrolle 11 links oben) bei Bedarf zugleich mit der Hauptrolle 10 oder für sich mit einer erfindungsgemäß eingesetzten Messschicht 2 versehen sein.

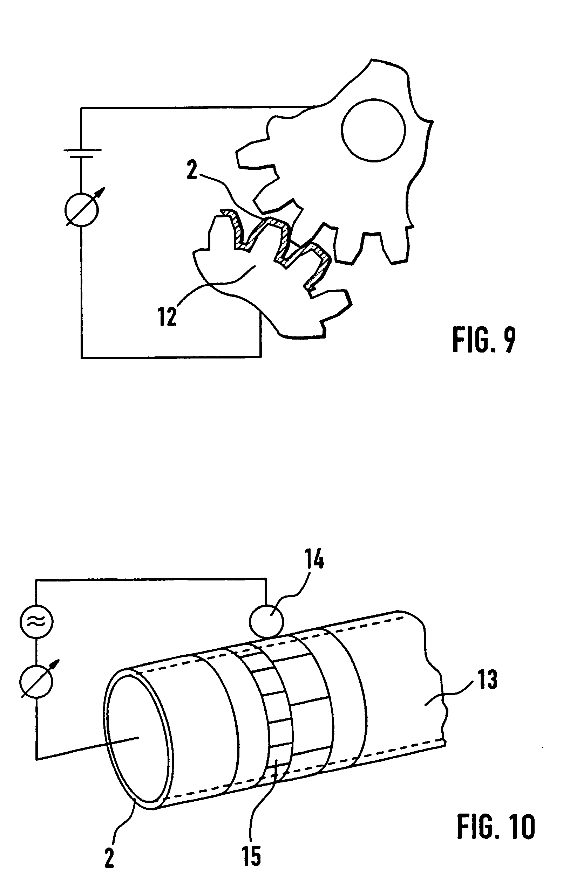

In **Figur 9** ist schematisch ein Zahnrad 12 dargestellt, das mit der erfindungsgemäß eingesetzten Messschicht 2 versehen ist. Hier erfüllt die Messschicht 2 neben den tribologischen Funktionen auch die Bestimmung von Kräften im Zahnflankenbereich, die mit anderen Techniken bisher nicht zugänglich sind.

In **Figur 10** ist eine Welle 13 gezeigt, die mit einem Schichtsystem als erfindungsgemäß eingesetzter Messschicht 2 versehen ist. Dabei soll die von einzelnen Kugeln oder Rollen 14 eines Lagers ausgeübte Kraft mit Hilfe der Messschicht 2 während des Betriebs kontinuierlich gemessen werden.

Anhand dieses konkreten Beispiels soll eine weitere Anwendungsform der erfindungsgemäß als Messschicht 2 eingesetzten Kohlenstoffschicht als Sensor zur lokalen Messung von Kraft oder anderen Zustandsgrößen an ansonsten nicht zugänglichen Stellen veranschaulicht werden.

Die kontinuierliche Messung in den nicht zugänglichen Lagern wird ermöglicht, indem die Welle 13 zunächst mit einer hochohmigen DLC-Schicht beschichtet wird.

Dabei wird ein CVD-Sputterprozess so geführt, dass zunächst nur die Substratelektrode - an der die Welle 13 befestigt ist - mit einem HF-Plasma bedient wird. Dabei wird neben Argon auch C₂H₂ und HMDSO (Hexamethyldisiloxan) in die Prozesskammer eingeleitet. Nach der Abscheidung von einer 2 µm dicken DLC-Schicht wird der Prozess modifiziert, indem neben der Substratelektrode auch die Targetelektrode mit einem HF-Plasma beaufschlagt wird. Die Targetelektrode kann zum Beispiel aus Wolfram bestehen. In einer bevorzugten Ausführung des Prozesses wird in einem ersten Schritt nur Argon eingeleitet und das Wolframtarget gegen einen Shutter von Kontaminationen gereinigt.

In dieser Phase liegt am Substrat ein Biaspotential an, das zu einem geringen Ätzvorgang führt.
In einer zweiten Phase wird der Shutter geöffnet und eine Zwischenschicht aus Wolfram mit einer Dicke von ca. 50 nm abgeschieden. Eine weitere Phase dient der Erzeugung einer Gradientenschicht aus Me:CH. Hierzu wird ein kontinuierlich steigender Anteil von C₂H₂ zu dem Argon-Sputtergas hinzugegeben. Diese Zwischenschicht hat eine Dicke von ca. 300 nm. Nach Erreichen des Enddruckes wird der C₂H₂-Fluss konstant gehalten und eine ca. 1 µm dicke W:CH-Schicht abgeschieden, die ca. 30 at-% W enthält.

Diese Schicht wird, wie in Figur 10 durch das Bezugszeichen 15 angedeutet, strukturiert. Dabei können bekannte photolithographische oder laserbasierende Strukturierungsverfahren zum Einsatz kommen. Dabei werden definierte Messzonen als Beobachtungsfenster 7 und Leiterbahnen einschließlich geeigneter Kontaktflächen 8 für zum Beispiel eine vom Messort entfernt angeordnete Schleifkontaktanordnung hergestellt.

Der nächste Schritt dient dem Aufbau einer isolierenden Schicht 6 auf der strukturierten Unterlage. Hierzu wird zum Beispiel eine mechanische Stencilmaske verwendet, die die Oberfläche der Welle 13 mit Ausnahme der Messzonen und der Schleifkontaktflächen abdeckt. Es wird dann eine hochohmige Schicht von ca. 1,5 µm Dicke nach dem vorstehend beschriebenen Verfahren aufgebracht. Anschließend wird die mechanische Maske entfernt.

Der weitere Schichtaufbau erfolgt, indem die Welle 13 erneut zum Beispiel in die CVD-Sputterantage eingebaut wird. Nun erfolgt die Abscheidung einer DLC-Schicht nach dem vorstehend beschriebenen Verfahren. Die Dicke dieser Schicht beträgt ca. 2 µm. Anstelle der DLC-Schicht kann auch eine Me:CH-Schicht auf die strukturierte W:CH-Schicht aufgebracht werden. Dabei muss der spezifische Widerstand der Schicht, der über den Me-Anteil gesteuert wird, höher sein, als der der strukturierten Unterlage. Vorteilhafterweise wird hier dann eine W:CH-Schicht mit einem W-Anteil von etwa 5 at-% eingesetzt.

Anstelle von Wolfram können auch andere Elemente Me für die Me:CH-Schicht verwendet werden, zum Beispiel Ti:CH, Ta:CH, Nb:CH etc..

Wie vorstehend bereits erwähnt, zeigt diese Ausführungsform die lokale Messung von Zustandsgrößen, hier der Kraft, in nicht zugänglichen Lagern.

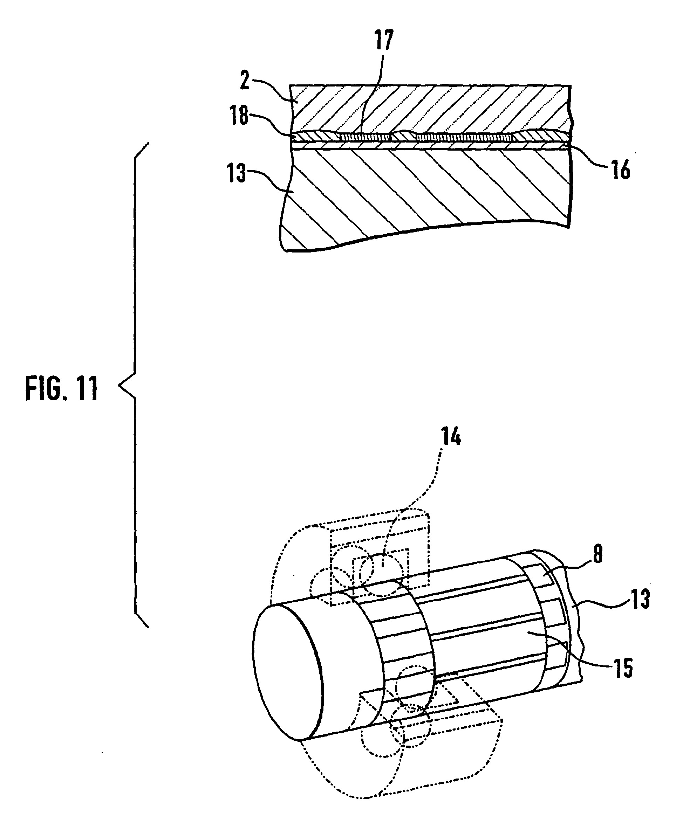

In **Figur 11** zeigt die obere Abbildung den Aufbau des Schichtsystems gemäß Figur 10 und die untere Abbildung eine schematische Gesamtansicht des in Figur 10 dargestellten Lagers mit Welle 13, Kugeln / Rollen 14 sowie der Strukturierung 15 für zum Beispiel Kontakte 8 und Leiterbahnen.

Der Ausschnitt gemäß der oberen Abbildung in Figur 11 zeigt hierbei die Welle 13, auf der eine hochohmige Schicht 16 nach dem vorstehend beschriebenen Verfahren abgeschieden ist. Darauf befindet sich eine strukturierte niederohmige Me:CH-Schicht 17 mit Strukturen für zum Beispiel Kontakte und Leiterbahnen sowie eine hochohmige Schicht 18 analog der hochohmigen Schicht 17 und als Messschicht 2 eine DLC- oder Me:CH-Schicht.

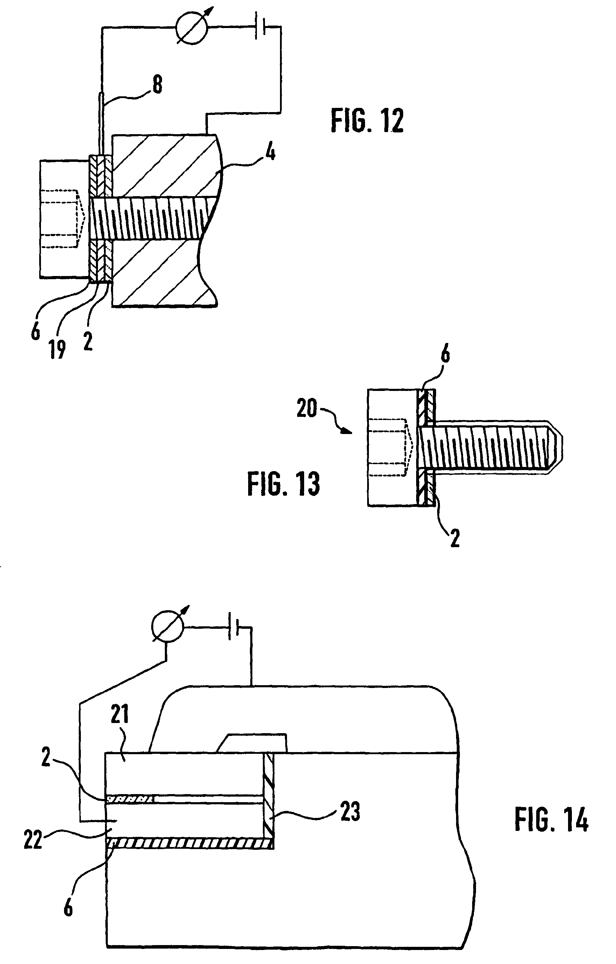

In **Figur 12** ist als weitere Anwendungsmöglichkeit der vorliegenden Erfindung eine Unterlegscheibe 19 gezeigt, die mit der erfindungsgemäß als Sensor eingesetzten Messschicht 2 versehen wurde, und die zur Messung und Kontrolle von kraftschlüssigen Verbindungen eingesetzt werden kann. Die hier gezeigte isolierende Schicht 6 kann zum Beispiel eine Si-O-DLC- oder Al₂O₃-Schicht sein. Als Messschicht 2 kann wiederum eine DLC- oder Me:CH-Schicht eingesetzt werden.

**Figur 13** zeigt als weitere Anwendungsform einen Schraubenkopf 20, der mit der erfindungsgemäß eingesetzten Messschicht 2 sowie einer isolierenden Schicht 6 versehen ist.

In **Figur 14** ist die Anwendung der erfindungsgemäß als Messschicht 2 eingesetzten amorphen Kohlenstoffschicht mit piezoresistiven Eigenschaften in einem Drehmeisel zur Messung der Zerspankraft gezeigt. Hier wird eine Unterlegplatte 22 (Unterlage) mit der Messschicht 2 beschichtet. Die Messschicht 2 kann ganzflächig oder in einer vorteilhaften Ausführung auch nur in einem oder mehreren separat kontaktierbaren Bereichen aufgebracht werden.

Der Drehmeisel ist mit einer Wenderschneidplatte 21, einer isolierenden keramischen Platte 23 sowie einer isolierenden Schicht 6 ausgestattet.

Wie vorstehend anhand zahlreicher Beispiele gezeigt, kann die erfindungsgemäß als Sensor zur Bestimmung von Zustandsgrößen wie Kraft oder Druck eingesetzte amorphe Kohlenstoffschicht mit piezoresistiven Eigenschaften variabel eingesetzt werden und auf einfache Art und Weise an die jeweiligen Anforderungen der jeweiligen Ausführungsformen angepasst werden. Dabei kann die Schicht als einzelne Schicht oder auch als beliebig ausgestaltetes Schichtsystem zum Einsatz kommen. Über die Art und Anzahl der Dotierungselemente können die jeweiligen Eigenschaften der Schicht beziehungsweisedes Schichtsystems beliebig variiert werden.

### Bezugszeichenliste

- 1: mechanische Komponente
- 2: Messschicht (Sensor)
- 3: Stempel
- 4: Gegenkörper
- 5: Schaltkreis
- 6: isolierende Schicht
- 7: Beobachtungsfenster
- 8: Kontakt
- 9: Isolationsschicht für Kontakt
- 10: Hauptrolle

- 11: Andruckrolle
- 12: Ausschnitt eines Zahnrades
- 13: Welle
- 14: Kugel / Rolle
- 15: Strukturierung
- 16: hochohmige Schicht
- 17: niederohmige Schicht mit Strukturierung für zum Beispiel Kontakte und Leiterbahnen
- 18: hochohmige Schicht
- 19: Unterlegscheibe
- 20: Schraubenkopf

- 21: Wenderschneidplatte
- 22: Unterlage (hier Unterlegplatte)
- 23: Isolierte keramische Platte

## Patentansprüche

1. Verwendung einer piezoresistiven Schicht als Sensor zur Messung von aktuellen Zustandsgrößen an beanspruchten Oberflächen von mechanischen Komponenten,
**dadurch gekennzeichnet,**
**dass** die piezoresistive Schicht eine amorphe Kohlenstoffschicht mit piezoresistiven Eigenschaften ist und als einzelne Schicht oder als Schichtsystem, die beanspruchten Oberflächen beschichtet,
wobei die amorphe Kohlenstoffschicht eine Kohlenstoffwasserstoffschicht mit 0,1 bis 35 at-% Wasserstoff ist.

2. Verwendung nach Anspruch 1,
**dadurch gekennzeichnet,**
**dass** als Zustandsgrößen die Kraft, die auf die Oberfläche einwirkt, und/oder der Druck gemessen werden.

3. Verwendung nach Anspruch 1 oder 2,
**dadurch gekennzeichnet,**
**dass** die amorphe Kohlenstoffschicht graphitische Strukturen mit sp²-Hybridisierung in Kombination mit diamantähnlichen Strukturen mit sp³-Hybridisierung aufweist.

4. Verwendung nach einem der vorhergehenden Ansprüche,
**dadurch gekennzeichnet,**
**dass** die amorphe Kohlenstoffschicht mit mindestens einem metallischen und/oder nicht metallischen Element dotiert ist.

5. Verwendung nach Anspruch 4,
**dadurch gekennzeichnet,**
**dass** das mindestens eine Element ausgewählt ist unter Si, Ti, W, Cr, Ta, Nb, V, Zr, Hf, Mo, Pb, Cu, Al, Au, Ag, Pt, Ru, Pd, Ni, Co, Sauerstoff, Stickstoff, Ar, F oder Kombinationen davon, insbesondere unter Si, Ti, W und Cr.

6. Verwendung nach Anspruch 4 oder 5,
**dadurch gekennzeichnet,**
**dass** das mindestens eine Element in der amorphen Kohlenstoffschicht in einer Menge von 0,01 bis 47 at-%, vorzugsweise 1 bis 45 at-%, enthalten ist.

7. Verwendung nach einem der vorhergehenden Ansprüche,
**dadurch gekennzeichnet,**
**dass** die amorphe Kohlenstoffschicht als verschleißfester Drucksensor auf beanspruchten Oberflächen von Werkzeugen und tribologisch beanspruchten Bauteilen aufgebracht ist.

8. Verwendung nach einem der Ansprüche 1 bis 6,
**dadurch gekennzeichnet,**
**dass** die amorphe Kohlenstoffschicht als anti-adhäsiver Drucksensor auf beanspruchten Oberflächen von Werkzeugen und Bauteilen aufgebracht ist.

9. Verwendung nach einem der vorhergehenden Ansprüche,
**dadurch gekennzeichnet,**
**dass** die amorphe Kohlenstoffschicht in Verbindung mit weiteren Funktionsschichten eingesetzt wird.

10. Verwendung nach Anspruch 9,
**dadurch gekennzeichnet,**
**dass** die amorphe Kohlenstoffschicht integraler Schichtbestandteil in einem Mehrschichtsystem ist.

11. Verwendung nach einem der vorhergehenden Ansprüche,
**dadurch gekennzeichnet,**
**dass** die Zusammensetzung einer oder mehrerer Schichten in Bezug auf die schichtaufbauenden Komponenten und/oder die Konzentration einzelner schichtaufbauender Komponenten über die Schichtdicke variiert.

12. Sensoranordnung zur Messung von aktuellen Zustandsgrößen von beanspruchten Oberflächen von mechanischen Komponenten (1),
**dadurch gekennzeichnet,**
**dass** als Sensor (2) eine piezoresistive amorphe Kohlenstoffschicht mit Zusammensetzung und strukturellen Merkmalen gemäß einem der Ansprüche 1 bis 11 eingesetzt wird,
wobei die amorphe Kohlenstoffschicht als einzelne Schicht oder als Schichtsystem die beanspruchten Oberflächen beschichtet, und
wobei die amorphe Kohlenstoffschicht über elektrische Kontakte (8) mit einer Messeinrichtung verbunden ist.

13. Sensoranordnung nach Anspruch 12,
**dadurch gekennzeichnet,**
**dass** zwischen der amorphen Kohlenstoffschicht als Messschicht (2) und der Oberfläche der mechanischen Komponente (1)eine isolierende Schicht (6) angeordnet ist, die mindestens an einer Stelle unterbrochen ist, zur Messung der lokalen Beanspruchung der mechanischen Komponente (1) an dieser Stelle.

## Claims

1. Use of a piezoresistive layer as a sensor for measuring actual state variables at stressed surfaces of mechanical components
**characterized in**
**that** the piezoresistive layer is an amorphous carbon layer with piezoresistive properties and is applied as single layer or as layer system onto the stressed surfaces,
wherein the amorphous carbon layer is a hydrocarbon layer containing 0.1 to 35 atom% hydrogen.

2. Use according to claim 1,
**characterized in**
**that** as state variables the force, which is acting upon the surface, and/or the pressure is measured.

3. Use according to claim 1 or 2,
**characterized in**
**that** the amorphous carbon layer comprises graphitic structures with sp² hybridization in combination with diamond-like structures with sp³ hybridization.

4. Use according to one of the preceding claims,
**characterized in**
**that** the amorphous carbon layer is doped with at least one metallic and/or non-metallic element.

5. Use according to claim 4,
**characterized in**
**that** the at least one element is selected from Si, Ti, W, Cr, Ta, Nb, V, Zr, Hf, Mo, Pb, Cu, Al, Au, Ag, Pt, Ru, Pd, Ni, Co, oxygen, nitrogen, Ar, F or combinations thereof, in particular from Si, Ti, W and Cr.

6. Use according to claim 4 or 5,
**characterized in**
**that** the at least one element is contained in the amorphous carbon layer in a quantity of 0.01 to 47 atom %, preferably 1 to 45 atom %.

7. Use according to one of the preceding claims,
**characterized in**
**that** the amorphous carbon layer is applied as a wear-resistant pressure sensor onto the surfaces of tools and tribologically stressed components.

8. Use according to one of claims 1 to 6,
**characterized in**
**that** the amorphous carbon layer is applied as an anti-adhesive pressure sensor onto the stressed surfaces of tools and components.

9. Use according to one of the preceding claims,
**characterized in**
**that** the amorphous carbon layer is used in combination with further functional layers.

10. Use according to claim 9,
**characterized in**
**that** the amorphous carbon layer is an integral layer component in a multilayer system.

11. Use according to one of the preceding claims,
**characterized in**
**that** the composition of one or more layers varies, in terms of the layer-forming components and/or the concentration of individual layer-forming components, over the layer thickness.

12. Sensor arrangement for measuring actual state variables of stressed surfaces of mechanical components (1),
**characterized in**
**that** as sensor (2) a piezoresistive amorphous carbon layer is used having the composition and structural features in accordance with one of claims 1 to 11, wherein the amorphous carbon layer covers the stressed surfaces as single layer or as layer system, and wherein the amorphous carbon layer is connected by electrical contacts (8) to a measuring device.

13. Sensor arrangement according to claim 12,
**characterized in**
**that** disposed between the amorphous carbon layer as measuring layer (2) and the surface of the mechanical component (1) is an insulating layer (6), which is interrupted at least at one point, for measuring the local stress of the mechanical component (1) at said point.

## Revendications

1. Utilisation d'une couche piézorésistive comme capteur pour mesurer les paramètres d'état actuel de surfaces de composants mécaniques sollicitées,
**caractérisée en ce**
**que** la couche piézorésistive est une couche de carbone amorphe ayant des propriétés piézorésistives et recouvre les surfaces sollicitées sous la forme d'une couche individuelle ou d'un système de couches, où la couche de carbone amorphe est une couche de carbone - hydrogène comprenant 0,1 à 35 % atmosphériques d'hydrogène.

2. Utilisation selon la revendication 1,
**caractérisée en ce**
**que** l'on mesure la force qui agit sur la surface et/ou la pression comme paramètres d'état.

3. Utilisation selon la revendication 1 ou 2,
**caractérisée en ce**
**que** la couche de carbone amorphe présente des structures graphitiques avec une hybridation sp² combinées à des structures de type diamant avec une hybridation sp³.

4. Utilisation selon l'une des revendications précédentes,
**caractérisée en ce**
**que** la couche de carbone amorphe est dopée avec au moins un élément métallique et/ou un élément non métallique.

5. Utilisation selon la revendication 4,
**caractérisée en ce**
**que** le au moins un élément est choisi parmi Si, Ti, W, Cr, Ta, Nb, V, Zr, Hf, Mo, Pb, Cu, Al, Au, Ag, Pt, Ru, Pd, Ni, Co, l'oxygène, l'azote, Ar, F ou des combinaisons de ceux-ci, notamment parmi Si, Ti, W, et Cr.

6. Utilisation selon la revendication 4 ou 5,
**caractérisée en ce**
**que** le au moins un élément est présent dans la couche de carbone amorphe en une quantité de 0,01 à 47 % atmosphériques, de préférence 1 à 45 % atmosphériques.

7. Utilisation selon l'une des revendications précédentes,
**caractérisée en ce**
**que** la couche de carbone amorphe est déposée sur les surfaces sollicitées d'outils et de pièces de construction subissant des contraintes tribologiques sous la forme d'un capteur de pression résistant à l'usure.

8. Utilisation selon l'une des revendications 1 à 6,
**caractérisée en ce**
**que** la couche de carbone amorphe est déposée sur les surfaces sollicitées d'outils et de pièces de construction sous la forme d'un capteur de pression anti-adhésif.

9. Utilisation selon l'une des revendications précédentes,
**caractérisée en ce**
**que** la couche de carbone amorphe est utilisée en relation avec d'autres couches fonctionnelles.

10. Utilisation selon la revendication 9,
**caractérisée en ce**
**que** la couche de carbone amorphe est une composante de couche intégrée d'un système multicouches.

11. Utilisation selon l'une des revendications précédentes,
**caractérisée en ce**
**que** la composition d'une ou de plusieurs couches varie en rapport avec les composants structurant les couches et/ou la concentration des différents composants structurant les couches sur toute l'épaisseur des couches.

12. Dispositif de capteur pour mesurer les paramètres d'état actuel de surfaces de composants mécaniques (1) sollicitées,
**caractérisé en ce**
**que** l'on met en oeuvre à titre de capteur (2) une couche de carbone amorphe piézorésistive ayant la composition et les caractéristiques structurelles selon l'une des revendications 1 à 11, où la couche de carbone amorphe recouvre les surfaces sollicitées sous la forme d'une couche individuelle ou d'un système de couches, et où la couche de carbone amorphe est reliée à un appareil de mesure par le biais de contacts électriques (8).

13. Dispositif de capteur selon la revendication 12,
**caractérisé en ce**
**qu'**une couche isolante (6), qui est discontinue au moins en un endroit, est disposée entre la couche de carbone amorphe à titre de couche de mesure (2) et la surface du composant mécanique (1) dans le but de mesurer la sollicitation locale du composant mécanique (1) à cet endroit.
